# EUROPÄISCHE PATENTANMELDUNG

(11) **EP 4 250 381 A1**
(43) Veröffentlichungstag der Anmeldung: **27.09.2023**
(21) Anmeldenummer: 22164288.7
(22) Anmeldetag: 25.03.2022
(51) Int. Cl.: H01L 51/42

(54) **ORGANISCHES HALBLEITERMATERIAL SOWIE EINE PHOTOVOLTAIKZELLE**

(71) Anmelder: HEION GmbH, 23623 Siblin (DE)
(72) Erfinder: Ledwon, Anton, 53842 Troisdorf (DE); Lewtschenko, Waldemar, 53773 Hennef (DE)
(74) Vertreter: Wagner Albiger & Partner Patentanwälte mbB

(57) **Zusammenfassung**

Organisches Halbleitermaterial, enthaltend einen Anteil 50 bis 80% amorphen Siliziums oder Titanoxids oder eines anderen Metalloxids oder einer Mischung daraus, wobei das amorphe Silizium und/oder Titanoxid und/oder das andere Metalloxid in Pulverform mit dem organischen Halbleitermaterial verknetet ist.

## Beschreibung

Die vorliegende Erfindung betrifft ein organisches Halbleitermaterial sowie eine Photovoltaikzelle mit einem derartigen organischen Halbleitermaterial.

Photovoltaikzellen (" Solarzellen") zur Gewinnung elektrischer Energie aus Sonnenlicht sind seit langem bekannt und zunehmend verbreitet. Sie bestehen häufig aus Silizium, wobei jedoch an alternativen Materialien geforscht wird. Bekannt sind beispielsweise Grätzel-Zellen, bei denen Farbstoffmoleküle das einfallende Licht absorbieren und freie Ladungsträger abgeben. Ferner sind auch Perowskit-Solarzellen bekannt, die anstelle eines organischen Absorbers eine Perowskitschicht verwenden.

Die neuartigen Technologien weisen gegenüber herkömmlichen Solarzellen auf Siliziumbasis häufig den Vorteil auf, dass sie einfacher herstellbar und/oder in bestimmten Wellenlängenbereichen oder über das gesamte Spektrum effizienter sind und/oder günstige mechanische Eigenschaften aufweisen.

Nachteilig ist jedoch bei allen bekannten Technologien, dass eine Photovoltaikzelle elektrische Energie lediglich dann zur Verfügung stellt, wenn eine ausreichende Sonneneinstrahlung vorhanden ist. Wird elektrische Energie zu anderen Zeiten benötigt, muss auf Energie aus anderen Quellen oder auf eine verhältnismäßig aufwändige Speicherung beispielsweise in Akkumulatoren zurückgegriffen werden.

Aus der WO 03/050 886 A2 ist ein Dünnschicht-Energiesystem bekannt, bei dem eine Photovoltaikzelle zusammen mit einem Speicher für elektrische Energie in einer verhältnismäßig dünnen Schicht integriert ist. Ein derartiges System ist jedoch verhältnismäßig kompliziert aufgebaut und erfordert eine verhältnismäßig dicke Elektrolytschicht, die der Miniaturisierung enge Grenzen setzt.

Zudem besteht bei zahlreichen bekannten Technologien das Problem, dass die Herstellung der Photovoltaikzellen knappe Rohstoffe erfordert und/oder der Herstellungsprozess verhältnismäßig aufwendig ist.

Es ist daher eine Aufgabe der vorliegenden Erfindung, ein Halbleitermaterial und eine Photovoltaikzelle mit diesem Halbleitermaterial anzugeben, wobei das Halbleitermaterial besonders günstige Eigenschaften in Bezug auf die Energieausbeute beim Einsatz in einer Photovoltaikzelle und gleichzeitig besonders günstige Eigenschaften bei der Speicherung elektrischer Energie aufweist. Zudem soll das organische Halbleitermaterial möglichst kostengünstig und nachhaltig herstellbar sein.

Diese Aufgabe wird gelöst mit dem Gegenstand der unabhängigen Patentansprüche. Vorteilhafte Ausführungsformen und Weiterbildungen sind Gegenstand der Unteransprüche.

Gemäß einem Aspekt der Erfindung wird ein organisches Halbleitermaterial angegeben, enthaltend einen Anteil von 50 bis 80% amorphen Siliziums oder Titanoxids oder eines anderen Metalloxids oder einer Mischung daraus, wobei das amorphe Silizium und/oder Titanoxid und/oder das andere Metalloxid in Pulverform mit dem organischen Halbleitermaterial verknetet ist.

Dabei kann der Anteil des amorphen Siliziums und/oder Titanoxids und/oder des anderen Metalloxids ausgehend von einer Oberfläche des Halbleitermaterials abnehmen, wobei auf der Oberfläche des Halbleitermaterials eine ITO (Indiumzinnoxid)-Schicht angeordnet ist. Das ITO kann dabei nach herkömmlichen Verfahren aufgebracht sein, beispielsweise durch Sputtern oder Sol-Gel-Verfahren. Es kann jedoch auch in Pulverform in die Oberfläche des Halbleitermaterials eingeknetet werden.

Da das amorphe Silizium und/oder das Titanoxid und/oder das andere Metalloxid in Pulverform mit den übrigen Bestandteilen verknetet wird, ist kein Schmelzverfahren erforderlich. Somit können als Zusätze auch Materialien verwendet werden, die sonst durch eine thermische Behandlung (aufschmelzen) ihre Halbleitereigenschaft oder andere günstige Eigenschaften verlieren würden.

Bei dem Vermischen der Zusätze aus Silizium und/oder Titanoxid und/oder des anderen Metalloxids findet keine chemische Reaktion zwischen den Zusätzen und dem organischen Halbleitermaterial statt. Durch das feine Verkneten werden die Materialien lediglich derart miteinander in Kontakt gebracht, dass die Energiebarrieren der vielen Molekül- und Phasengrenzen im Gemisch gesenkt werden, so dass eine hohe Beweglichkeit der Elektronen gegeben ist, höher als in einem organischen Halbleiter ohne Siliziumanteil Zusätze.

Gemäß einem weiteren Aspekt der Erfindung wird ein organisches Halbleitermaterial angegeben, das herstellbar ist durch das folgende Verfahren: Zunächst erfolgt die Herstellung eines Gemischs aus 47% Pyrolyseöl, 47%Triglyceriden sowie 6% Kaliumhydroxid und die Erwärmung des Gemischs bis zur Vernetzung, wobei die Prozentangaben hier und im Folgenden Gewichtsprozent bedeuten. Die für die Vernetzung erforderliche Erwärmungstemperatur hängt von verschiedenen Faktoren ab, beispielsweise vom Wassergehalt und der Zusammensetzung des Pyrolyseöls. Typischerweise tritt eine Vernetzung bei etwa 170°C auf. Das Gemisch wird unter Feuchtigkeitsabschluss auf Raumtemperatur abgekühlt, um ein erstes Material zu erhalten, das insbesondere als hellbraune Creme oder Paste ausgebildet ist.

Zur Herstellung eines zweiten Materials erfolgt die Zugabe von vorzugsweise 0,5% bis 2,5% eines Stoffes ausgewählt aus der Gruppe bestehend aus Kaliumhydroxid, Natriumhydroxid oder Lithiumhydroxid zu einer Menge des Pyrolyseöls. Das Gemisch wird unter Rühren und Stampfen (insbesondere mit einem Metallstößel) auf ca. 100 - 120°C oder höher erwärmt und nachfolgend auf Raumtemperatur abgekühlt und zentrifugiert, um ein klares Öl sowie einen Bodensatz als zweites Material zu erhalten. Das klare Öl lässt sich in verschiedenen chemischen Prozessen weiterverwenden.

Eine Mischung aus dem ersten Material und dem zweiten Material, beispielsweise im Verhältnis 1:1, wird bei einer Destillationstemperatur von 120°C bis 300°C destilliert, um den Rückstand als drittes Material zu erhalten. Anschließend kann das erste, zweite und dritte Material kombiniert werden zu einem Aufbau mit inhomogener Zusammensetzung.

Innerhalb des Aufbaus mit inhomogener Zusammensetzung kann insbesondere eine Konzentration des dritten Materials in einer ersten Raumrichtung abnehmen.

Bei dem beschriebenen Herstellungsverfahren wird ein organisches Halbleitermaterial erhalten mit Kohlenwasserstoffverbindungen, wobei eine Dotierung durch die unterschiedlichen Gehalte an dotierenden Elementen wie Schwefel, Phosphor, Kalzium u.a., die aus dem Pyrolyseöl abgespalten und im Bodensatz oder im Destillationsrückstand aufkonzentriert werden, bewirkt wird. Somit ergeben sich bei dem Aufbau mit inhomogener Zusammensetzung auch Variationen der Leitfähigkeit, die im dritten Material am höchsten ist.

Gemäß einer vorteilhaften Ausführungsform weist das organische Halbleitermaterial Zusätze von Silizium und/oder Titanoxid auf, wobei eine Konzentration des Siliziums und/oder Titanoxids in einer ersten Raumrichtung zunimmt.

Ein derartiger Aufbau kann als aktives Material in einer Photovoltaikzelle verwendet und derart ausgerichtet werden, dass das Licht entgegengesetzt zur ersten Raumrichtung von derjenigen Seite aus einfällt, die die höchste Konzentration an Silizium und/oder Titanoxid aufweist. Die höchste Konzentration des dritten Materials befindet sich dann im Bereich der einen Elektrode. Wie sich herausgestellt hat und weiter unten näher erläutert wird, weist eine derartige Photovoltaikzelle besonders günstige Eigenschaften auf.

Das erfindungsgemäße organische Halbleitermaterial weist das erste, das zweite und das dritte Material auf, die in einem Schichtaufbau miteinander kombiniert werden können. Insbesondere kann eine erste Schicht vorgesehen sein, die eine Zusammensetzung aus 60 bis 80%, insbesondere 70 %, des dritten Materials, 20 bis 40%, insbesondere 27 %, des zweiten Materials sowie 1 bis 5%, insbesondere 3 %, des ersten Materials aufweist. Eine benachbarte zweite Schicht kann eine Zusammensetzung von 60 bis 80%, insbesondere 70 %, des ersten Materials, 20 bis 30%, insbesondere 25 %, des zweiten Materials und wenigen Prozent des dritten Materials sowie Zusätzen von Silizium und/oder Titanoxid aufweisen. Eine zur zweiten Schicht benachbarte dritte Schicht kann eine Zusammensetzung von 80 bis 90%, insbesondere 85 %, Silizium und/oder Titanoxid, 10 bis 18%, insbesondere 14 %, des ersten Materials und 0,5 bis 3%, insbesondere 1%, des zweiten Materials aufweisen.

Übergangsbereiche zwischen den Schichten weisen typischerweise gemischte Zusammensetzungen auf, so dass sich die Zusammensetzung der Schichten nicht abrupt, sondern kontinuierlich ändert.

Das Pyrolyseöl, das einen wichtigen Ausgangsstoff für das Verfahren darstellt, kann insbesondere aus Kunststoffabfällen gewonnen werden. Hierfür ist beispielsweise das sogenannte Hamburger Verfahren bekannt, bei dem Kunststoffmischabfälle chemisch recycelt werden. Das Pyrolyseöl kann aus einer Vielzahl chemischer Verbindungen bestehen wie Carbonsäuren, Phenolen, Aldehyden, Alkoholen, Furanen und organischen Säuren.

Wie sich herausgestellt hat, weist das auf die beschriebene Weise herstellbare organische Material als Komponente zur Verwendung in Photovoltaikzellen günstige Eigenschaften auf. Es lässt sich sowohl als aktives Material in einer Photovoltaikzelle zur Umwandlung von Sonnenenergie in elektrische Energie nutzen als auch zur Speicherung elektrischer Energie, wie weiter unten ausführlicher beschrieben wird. Zudem weist das organische Halbleitermaterial den Vorteil auf, dass es auf nachhaltige Weise aus recycelten Abfällen herstellbar ist und somit knappe Rohstoffressourcen schont.

Dem organischen Halbleitermaterial können abhängig von der Verwendung Stoffe wie insbesondere amorphes pulverförmiges Silizium oder Titanoxid zugesetzt werden (hier können andere Halbleitermaterialien pulverförmig ohne aufschmelzen für Solarzellen verwendet werden). Wie sich herausgestellt hat, verbessert die Zugabe von Silizium, insbesondere in Form von amorphem Silizium in Pulverform, die Absorptionsfähigkeit des organischen Halbleitermaterials im sichtbaren Bereich des elektromagnetischen Spektrums. Zudem bewirkt die Zugabe von Silizium eine erhöhte Beweglichkeit von Elektronen in dem organischen Halbleiter.

Anstelle von Silizium oder Titanoxyd oder zusätzlich können auch andere Metalloxyde in Pulverform verwendet werden, die gut in das Material eingeknetet werden, bis es feinkörnig ist. Beim Einkneten entstehen ein Bruch der Kristallstruktur und eine enge Vermischung mit dem ersten Material.

Die Zugabe von Titanoxid dagegen verbessert die Absorptionsfähigkeit bei kürzeren Wellenlängen, insbesondere im Bereich des UV- bzw. Röntgenlichts. Ein Halbleitermaterial mit derartigen Zusätzen kann daher insbesondere für den Einsatz außerhalb der Erdatmosphäre günstig sein, jedoch auch die Effizienz von auf der Erde eingesetzten Photovoltaikzellen verbessern.

Bei dem ersten, dem zweiten und dem dritten Material handelt es sich um Komponenten zur Herstellung organischer Halbleitermaterialien, die zur Verbesserung der Halbleitereigenschaften beispielsweise zusätzlich amorphes Silizium oder andere Metalloxyde enthalten kann. In dem Ausgangsmaterial Pyrolyseöl, das bei Raumtemperatur in flüssiger Form vorliegt und ein Gemisch von insbesondere Alkanen, Cykloalkanen und aromatischen Kohlenwasserstoffen ist, liegen lange Kohlenwasserstoffketten vor (typischerweise 15-30 Kohlenstoffatome) sowie ein hoher Anteil ungesättigter Kohlenwasserstoffe sowie Carbonsäuren. Während des beschriebenen Herstellungsverfahrens erfolgt eine Verbindung der Kohlenstoffketten zu langen Ketten, die über makroskopische Bereiche hinweg vernetzt sind. Das Material nimmt dabei eine plastische Eigenschaft an und lässt sich leicht in jede beliebige Form bringen. Bei der Synthese erfolgt die Zugabe einer starken Kalilauge, beispielsweise Kaliumhydroxid, zu dem Pyrolyseöl, die eine Deprotonierung der Kohlenwasserstoffe bewirkt. Die Kohlenwasserstoffreste verbinden sich dabei an den deprotonierten Stellen miteinander durch Ausbildung von kovalenten C-Einfach-, aber hauptsächlich C-Doppelbindungen.

Anschließend liegt in dem Material ein hoher Anteil an konjugierten Polymeren vor, in denen jedes Kohlenstoffatom eine Doppelbindung aufweist. Die Doppelbindung entsteht dadurch, dass zwischen zwei gebundenen Kohlenstoffatomen sowohl zwei σ -Bindungen als auch eine **π**-Bindung besteht. Dabei bilden das 2s-Orbital und das 2pₓ - und 2p_{y} - Orbital drei sp2-Hybridorbitale, wovon zwei für die Kohlenstoffverbindungen zur Verfügung stehen und eines an einer C-H-Verbindung beteiligt ist. Die **π** -Bindung wird durch die überlappenden 2p_{z}-Orbitale benachbarter Kohlenstoffatome gebildet. Eine Eigenschaft konjugierter Polymere ist, dass die Positionen der σ- und **π-**Bindungen nicht zwischen den Kohlenstoffatomen fest lokalisiert sind, sondern delokalisiert über die Kohlenstoffketten, sodass ein Ladungstransport über die gesamte Kette erfolgen kann.

Die Energiebeiträge des Bahn- und des Eigendrehimpulses der an einer Bindung beteiligten Elektronen ergibt bindende und antibindende Molekülorbitale, wobei letztere immer energetisch höher liegen. Das antibindende π-Orbital bildet das Hauptleitungsband des organischen Halbleiters, da der Energieunterschied zum bindenden π-Orbital im Bereich des sichtbaren Lichts liegt. Die verbotene Zone wird also hauptsächlich durch den Energieunterschied der π-Orbitale gebildet.

Das Pyrolyseöl enthält einen großen Anteil von Carbonsäuren. Während des Herstellungsverfahrens wird die Carbonsäuregruppe durch Zugabe von Kaliumhydroxid neutralisiert, indem das Hydroxidion ein Proton von der Carboxygruppe übernimmt und somit Derivate von Salzen der Kalilauge entstehen. Die Verschiebung der Negativladung hin zum Sauerstoff verleiht dem Molekülteil die Eigenschaft eines Elektronendonators sowie ein Dipolmoment.

Mit Zugabe von amorphem Silizium im Pyrolyseöl während der Synthese erhöht sich die Ausbeute der Photovoltaikzelle, da der Einbau von Silizium in die Kohlenstoffketten die Bindungsmöglichkeiten der Elektronen erhöht und sich folglich ein breiteres Spektrum der Energieunterschiede zwischen Valenz- und Leitungsband ergibt. Mehr Anteile des Sonnenlichts können folglich genutzt werden, um Elektronen vom Valenz- ins Leitungsband (oder besser: von dem HOMO (highest occupied molecular orbital) in das LUMO (lowest unoccupied molecular orbital)) anzuheben. Die entstehenden Verbindungen sind teilweise ähnlich wie Carbosilane aufgebaut, jedoch mit längeren Kohlenstoffketten insgesamt vernetzt und mit einem höheren Anteil an KohlenstoffDoppelbindungen.

Gemäß einem weiteren Aspekt der Erfindung wird eine Photovoltaikzelle angegeben, die zumindest eine erste Elektrode mit einer ersten Hauptoberfläche und einer zweiten Hauptoberfläche aufweist sowie eine zweite Elektrode mit einer ersten Hauptoberfläche und einer zweiten Hauptoberfläche. Ferner weist die Photovoltaikzelle zumindest eine Schicht des beschriebenen organischen Halbleitermaterials auf, wobei die Schicht zwischen der zweiten Hauptoberfläche der ersten Elektrode und der ersten Hauptoberfläche der zweiten Elektrode angeordnet ist.

Wie sich herausgestellt hat, eignet sich das organische Halbleitermaterial als aktives Material einer Photovoltaikzelle. Durch Wechselwirkung mit elektromagnetischer Strahlung wird eine Photospannung und somit elektrische Energie erzeugt. Ferner hat sich herausgestellt, dass das organische Halbleitermaterial auch zur Speicherung der erzeugten elektrischen Energie verwendet werden kann. Die Photovoltaikzelle hat somit den Vorteil, dass sie aus einem nachhaltig produzierten Material ausgebildet ist, das sich gleichzeitig sowohl für die Erzeugung als auch für die Speicherung elektrischer Energie eignet. Darüber hinaus kann das organische Halbleitermaterial flexibel ausgebildet sein und sich somit für eine Vielzahl von Anwendungen eignen.

Gemäß einer Ausführungsform sind mehrere Schichten des organischen Halbleitermaterials zwischen der zweiten Hauptoberfläche der ersten Elektrode und der ersten Hauptoberfläche der zweiten Elektrode angeordnet und die Schichten weisen unterschiedliche Mischungsverhältnisse des ersten, zweiten und dritten Materials auf.

Insbesondere kann es vorgesehen sein, dass zumindest drei Schichten des organischen Halbleitermaterials zwischen der zweiten Hauptoberfläche der ersten Elektrode und der ersten Hauptoberfläche der zweite Elektrode angeordnet sind und der Anteil des dritten Materials mit zunehmender Entfernung der Schicht von der ersten Elektrode abnimmt und der Anteil des ersten Materials mit zunehmender Entfernung der Schicht von der ersten Elektrode zunimmt. Die Schichtdicken der einzelnen Schichten können dabei im Bereich weniger Millimeter oder unterhalb von einem Millimeter, beispielsweise im Bereich von 0,5 mm liegen.

Als Material für die erste Elektrode ist beispielsweise Kohlenstoff geeignet. Die zweite Elektrode ist vorteilhafter Weise transparent ausgebildet, d.h. durchlässig für elektromagnetische Strahlung innerhalb des Spektralbereichs, in dem die Strahlung zur Erzeugung elektrischer Energie genutzt werden soll. Als Material ist beispielsweise Indiumzinnoxid (ITO) geeignet. Da Indium verhältnismäßig teuer ist, sind mittlerweile kostengünstigere alternative, transparente, leitfähige Materialien bekannt, beispielsweise Graphen, mit Aluminium dotiertes Zinkoxid oder mit Fluor dotiertes Zinnoxid. Auch diese Materialien wären zur Bildung der zweiten Elektrode geeignet.

Gemäß einer Ausführungsform ist zwischen zweien der zumindest drei Schichten eine teildurchlässige Membran angeordnet. Die Membran kann beispielsweise aus Zellstoff bestehen und hat die Aufgabe, den Rückfluss von Ladungsträgern aus den Bereichen nahe der ersten oder zweiten Elektrode in das aktive Material zu verhindern oder zu begrenzen. Dadurch kann eine höhere Spannung der Photovoltaikzelle erreicht werden.

Beispielhafte Ausführungsformen werden im Folgenden anhand schematischer Figuren näher beschrieben. Darin zeigen:
- Figur 1: eine Photovoltaikzelle gemäß einer Ausführungsform der Erfindung;
- Figur 2: die Photovoltaikzelle gemäß Figur 1 in größerem Detail;
- Figur 3: eine weitere Photovoltaikzelle;
- Figur 4: die Photovoltaikzelle gemäß den Figuren 1 und 2 und
- Figur 5: anhand eines Diagramms die Zusammensetzung des aktiven Materials eine Photovoltaikzelle gemäß einer Ausführungsform der Erfindung.

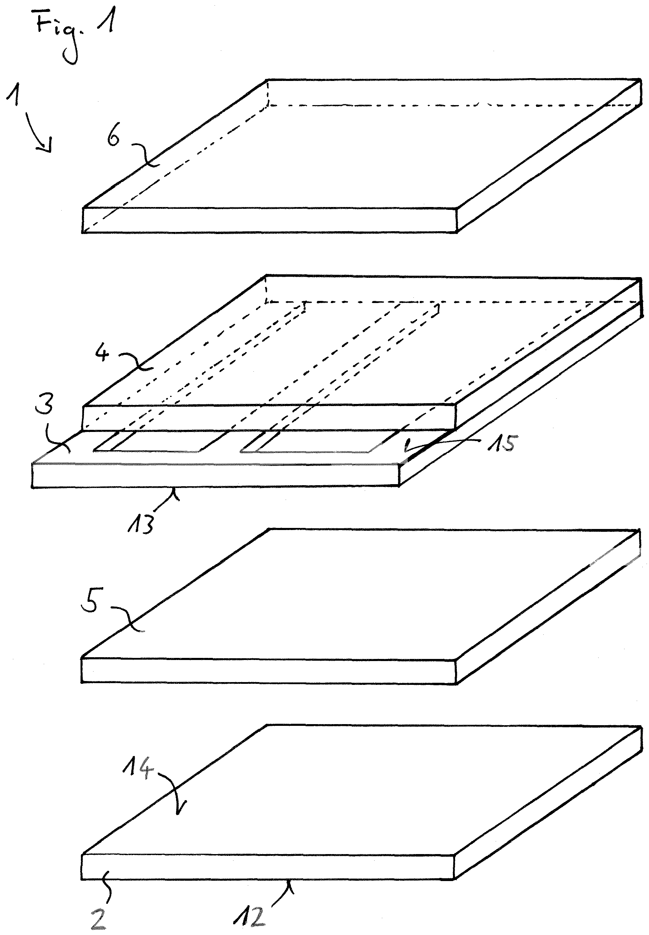

Figur 1 zeigt schematisch eine Photovoltaikzelle 1 gemäß einer Ausführungsform der Erfindung. Die Photovoltaikzelle 1 weist eine erste Elektrode 2 auf, die beispielsweise aus Kohlenstoff ausgebildet ist und eine erste Hauptoberfläche 12 und eine zweite Hauptoberfläche 14 aufweist. Zudem umfasst die Photovoltaikzelle 1 eine zweite Elektrode 3, die als Dünnschichtelektrode ausgebildet ist. Beispielsweise kann die Elektrode 3 als strom leitende Lackschicht oder als Metallstreifen ausgebildet sein. Die Elektrode 3 ist auf einer Metalloxidschicht 4 aufgebracht. Bei dem Metalloxid handelt es sich in der gezeigten Ausführungsform um Indiumzinnoxid (ITO), einen halbleitenden, im sichtbaren Licht weitgehend transparenten Stoff. Auf der Metalloxidschicht 4 kann eine lichtdurchlässige Isolationsschicht 6 angeordnet sein.

Die Elektrode 3 hat die Aufgabe, Elektronen von der Metalloxidschicht 4 zur ersten Elektrode 2 zu transportieren, wenn Licht einfällt und der äußere Stromkreis geschlossen wird. Ferner dient die Elektrode 2 dem Transport von in dem weiter unten beschriebenen aktiven Material 5 gespeicherter elektrischer Energie, wenn kein Licht einfällt.

Die Metalloxidschicht 4 aus Indiumzinnoxid dient selbst auch zur Erzeugung eines Photostroms. Für die Absorption von Photonenenergie ist dabei die Dicke der Metalloxidschicht ein wichtiger Parameter, weil sie die Bandbreite der absorbierbaren Frequenzen beeinflusst.

Die zweite Elektrode 3 weist eine erste Hauptoberfläche 13 auf, die der ersten Elektrode 2 zugewandt ist, sowie eine zweite Hauptoberfläche 15, die mit der Metalloxidschicht 4 in Kontakt steht. Zwischen der zweiten Hauptoberfläche 14 der ersten Elektrode 12 und der ersten Hauptoberfläche 13 der zweiten Elektrode 3 ist eine Schicht eines aktiven Materials 5 angeordnet. Bei dem aktiven Material 5 handelt es sich um das wie beschrieben herstellbare organische Halbleitermaterial.

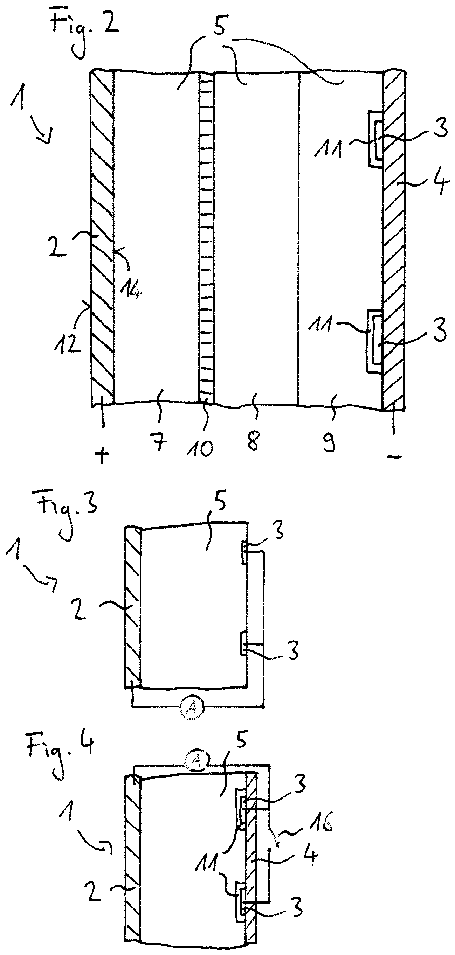

Figur 2 zeigt die Photovoltaikzelle 1 gemäß Figur 1 detaillierter. In der Querschnittsdarstellung ist erkennbar, dass die Schicht aus dem aktiven Material 5 selbst in mehrere Schichten unterteilt ist, nämlich in eine erste Schicht 7, die angrenzend zur ersten Elektrode 2 angeordnet ist, eine darauffolgende zweite Schicht 8 sowie eine dritte Schicht 9, die angrenzend zur zweiten Elektrode 3 und zur Metalloxidschicht 4 angeordnet ist. Die Schichten 7 bis 9 bestehen aus dem ersten, dem zweiten und dem dritten Material in unterschiedlichen Mischungsverhältnissen und gegebenenfalls mit unterschiedlichen Zusätzen insbesondere von halbleitenden Materialien wie Silizium und Titanoxid. Dabei weist die benachbart zur ersten Elektrode 2 angeordnete erste Schicht 7 in der gezeigten Ausführungsform eine Zusammensetzung aus 70 % des dritten Materials, 27 % des zweiten Materials sowie 3 % des ersten Materials auf und keine weiteren Zusätze. Diese Zusammensetzung ist insbesondere an der Grenzfläche zur ersten Elektrode 2 gegeben.

Die zweite Schicht 8 weist insbesondere in ihrem zentralen Bereich eine Zusammensetzung von 70 % des ersten Materials, 25 % des zweiten Materials und wenigen Prozent des dritten Materials sowie Zusätzen von Silizium und/oder Titanoxid auf.

Die dritte Schicht 9 weist insbesondere an der Grenzfläche zu der zweiten Elektrode 3 und der Metalloxidschicht 4 eine Zusammensetzung von 85 % Silizium und/oder Titanoxid, 14 % des ersten Materials und ein Prozent des zweiten Materials auf. Da die Schichten 7 bis 9 typischerweise in pastöser Form aufgetragen werden, findet eine gewisse Durchmischung im Bereich der Grenzen zwischen den jeweiligen Schichten statt. Die Zusammensetzung der Schichten 7, 8, 9 ändert sich demnach nicht abrupt an den schematisch gezeigten Grenzflächen, sondern kontinuierlich. Die Schichten 7 bis 9 weisen Schichtdicken im Bereich zwischen 0,5 mm und wenigen Millimetern auf.

Der Aufbau des aktiven Materials 5 aus drei Schichten, wie in Figur 2 gezeigt, kann auch abgewandelt werden und ersetzt werden durch einen Aufbau aus vielen, wesentlich dünneren Schichten. Anstelle von "Schichten" könnte man auch von "Zonen" sprechen, die unterschiedliche mittlere Materialzusammensetzungen und somit unterschiedliche Eigenschaften aufweisen. Eine Zone könnte gegebenenfalls aus mehreren Schichten bestehen, falls man als "Schicht" eine Menge an Material bezeichnet, das in einem Schritt mit homogener Zusammensetzung aufgebracht wurde.

Die Darstellung in Figur 2 und die Verwendung des Begriffs "Schicht" dient hier nur zur Veranschaulichung und soll nicht einschränkend verstanden werden. Da die Schichten 7, 8 und 9 in der gezeigten Ausführungsform aus pastösen Materialien aufgebracht wurden und sich in den Grenzbereichen teilweise durchmischen, ergeben ich quasi-kontinuierliche Übergänge der Materialzusammensetzung an den Schichtgrenzen.

In der in Figur 2 gezeigten Ausführungsform ist zwischen der ersten Schicht 7 und der zweiten Schicht 8 eine teildurchlässige Membran 10 aus einem Zellstoff angeordnet. Eine derartige Membran könnte alternativ auch zwischen der zweiten Schicht 8 und der dritten Schicht 9 vorgesehen sein.

Zwischen der zweiten Elektrode 3 und dem aktiven Material 5, insbesondere der dritten Schicht 9, ist eine Isolierung 11 vorgesehen.

Im Betrieb der Photovoltaikzelle 1 treffen Photonen auf die transparente Metalloxidschicht 4 und dringen in das aktive Material 5 ein. Die zweite Schicht 8 und die dritte Schicht 9 sind die fotoaktiven Schichten. Durch Einstrahlung von Sonnenlicht werden Elektronen des organischen Halbleiters und Kalium-Donatorelektronen freigesetzt und wandern in Richtung der (p-dotierten) zweiten Elektrode 3. Mit ihrem höheren Anteil am ersten Material hat die zweite Schicht 8 einen höheren Anteil an der Fotoaktivität. Daher ist die dritte Schicht 9 vorteilhafterweise ausreichend dünn, d.h. lichtdurchlässig, ausgebildet. Zwischen der zweiten Elektrode 3 und der zweiten Schicht 8 bildet sich ein elektrisches Feld aus.

Die zweite Elektrode 3 weist in der gezeigten Ausführungsform einen hohen Anteil Indium(III)-oxid (In2O3) und einen kleineren Anteil Zinn(IV)-oxid (SnO2) auf. Ein hoher Anteil von Silizium in der dritten Schicht 9 von beispielweise etwa 75% schafft eine gute elektrische Verbindung zwischen der Elektrode 3 und den fotoaktiven Schichten 8, 9. Da die zweite Schicht 8 mit dem hohen Anteil an dem ersten Material die dominierende fotoaktive Schicht darstellt, ist hier der Siliziumanteil geringer, aber ausreichend, damit die elektrische Verbindung zur dritten Schicht 9 besteht.

Es hat sich als vorteilhaft herausgestellt, das Silizium als amorphes Pulver zuzusetzen und möglichst fein und homogen mit dem ersten und zweiten Material zu vermischen. Dies senkt die Energiebarrieren der vielen Molekül- und Phasengrenzen im Gemisch, so dass eine hohe Beweglichkeit der Elektronen gegeben ist, höher als in einem organischen Halbleiter ohne Siliziumanteil.

Im Gegensatz zur zweiten und dritte Schicht 8, 9 enthält die erste Schicht 7 kein Silizium und weniger Kalium. Die elektrische Verbindung ist mit der Kohlenstoff-Elektrode 2 gegeben. Die Mischung ist so gewählt, dass weder n- noch p-Dotierung überwiegen, da sich sonst in der ersten Schicht 7 ein Störpotential ausbilden würde, welches die Schichten 8, 9 hemmen würde.

Im Betrieb erfolgt die Ausbildung eines elektrischen Feldes, bei dem sich 3 Teilfelder E1, E2 und ES addieren:
E1: Die p-dotierte Elektrode 3 grenzt an die Schicht 9, dies stellt das erste Teilstück des p-n-Übergangs dar. Elektronen wandern von der dritten Schicht 9 in die In(III)-Fehlstellen der Elektrode 3, womit sich hier ein Negativ-Potential ausbildet.
E2: Das zweite Quasi-p-n-Teilstück besteht zwischen der zweiten Schicht 8 und der dritten Schicht 9. Die zweite Schicht 8 stellt eine schwach dotierte n-Schicht angrenzend an eine stark dotierte n-Schicht dar. Der höhere Anteil des ersten Materials in der zweiten Schicht 8 bewirkt ein Dichtegefälle von Donatorelektronen, hiermit bildet sich ein Diffusionspotential. Vorteilhaft für dessen maximale Ausbildung ist, dass das amorphe Silizium möglichst fein mit der dem ersten bzw. zweiten Material vermischt ist. das zweite Material dient als eigentliche Elektronenquelle für die In(III)-Fehlstellen in der Elektrode 3.
ES: Die Elektronen wandern von der zweiten Schicht 8 zur Elektrode 3 und es bildet sich ein elektrisches Feld aus. Als weitere leitende Verbindung zwischen der Elektrode 3 und der zweiten Schicht kann ein Aluminium-Gitter verwendet werden. Die Verbindung zwischen dem mikrokristallinen Silizium und dem Aluminiumgitter stellt einen Metall-Halbleiterkontakt dar (Schottky-Kontakt). Dies bewirkt ein zusätzliches elektrisches Feld ES. Außerdem wirkt dieser Übergang wie eine Schottky-Diode und verhindert ein Selbstentladen. Somit wird ein Elektronenfluss zurück zu den Indium-Fehlstellen in der Elektrode 3 verhindert.

Wird nun ein Kontakt zwischen den Elektroden hergestellt, bewirkt der "Elektronendruck" in der Elektrode 3 den Ladungsausgleich über die Elektrode 2 zurück zur elektronenverarmten Schicht 8. Erst bei der Arbeitsspannung von ca. 1V wird die Membran 10 signifikant durchlässig für den Elektronenfluss, darunter stellt sie einen ohmschen Widerstand dar, der verhindert, dass Ladungen von der Schicht 8 zur Schicht 7 wandern und somit eine intrinsische Selbstentladung bewirken würden.

Im Gegensatz zum intrinsischen Feld einer klassischen Solarzelle, wo ein im Halbleiter vorhandenes Feld zwischen einem positiven n-dotierten Bereich und einem negativen p-dotierten Bereich den Stromfluss hervorruft, ist bei der hier gezeigten Solarzelle ein extrinsisches elektrisches Feld verursacht durch Elektronenüberschuss an der Elektrode 3 und Elektronenmangel an der Elektrode 2 die Ursache für den Ladungsfluss. Somit kann diese photovoltaische Zelle auch als Kondensator bezeichnet werden, der sich mit Hilfe von Sonnenenergie aufladen kann und über einen Selbstentladeschutz verfügt (Schottky-Diode + Membran).

Die teildurchlässige Membran 10 ist insbesondere aus Zellstoff ausgebildet und erhöht die Spannung der Photovoltaikzelle 1 erheblich. Im Falle einer Überspannung der Photovoltaikzelle 1 würden ohne die Membran 10 Ladungsträger aus dem Bereich der Elektroden 2, 3 wieder vermehrt zurück in das aktive Material 5 wandern.

Figur 3 zeigt schematisch eine Photovoltaikzelle 1, die dasselbe aktive Material 5 zwischen den Elektroden 2, 3 aufweist wie die in den Figuren 1 und 2 beschriebene Photovoltaikzelle 1. Sie unterscheidet sich jedoch von der in den Figuren 1 und 2 gezeigten Photovoltaikzelle 1 dadurch, dass die zweite Elektrode 3 nicht gegen das aktive Material 5 isoliert ist, und wird nur zu Erläuterungszwecken gezeigt: Wie sich herausgestellt hat, entsteht bei der gezeigten Anordnung ein elektrochemisches Potenzial zwischen den Elektroden 2 und 3 ohne Lichteinstrahlung. Das aktive Material 5 spielt dabei die Rolle eines Elektrolyten. Beim Anschluss einer Last fließt ein elektrischer Strom. Die Photovoltaikzelle 1 liefert dabei eine Spannung wie eine Batterie. Wenn kein äußerer Verbraucher angeschlossen ist, bleibt das elektrochemische Potenzial der Zelle erhalten. Die Selbstentladung ist sehr gering. Bei Einstrahlung von Licht steigt das elektrische Potenzial der Photovoltaikzelle 1, d.h. die Photovoltaikenergie und die elektrochemische Energie addieren sich.

Figur 4 zeigt die in Figur 3 gezeigte Photovoltaikzelle 1, wobei allerdings eine Isolation 11 zwischen der zweiten Elektrode 3 und dem aktiven Material 5 angeordnet ist. In diesem Fall ist kein elektrochemisches Potenzial nachweisbar, jedoch produziert die Photovoltaikzelle 2 elektrische Energie, wenn das aktive Material 5 mit Photonen wechselwirkt. Wie sich herausgestellt hat, wird diese Energie gespeichert, wenn der äußere Stromkreis unterbrochen wird, hier symbolisiert durch den Schalter 16. m Sie kann später durch Schließen des Stromkreises wieder abgerufen werden, auch wenn keine Lichteinstrahlung mehr stattfindet, obwohl die zweite Elektrode 3 gegenüber dem aktiven Material 5 elektrisch isoliert ist.

Somit ist das aktive Material 5 geeignet, nicht nur elektrische Energie aus eingestrahltem Licht zu erzeugen, sondern auch Energie zu speichern und zu einem späteren Zeitpunkt zur Verfügung zu stellen.

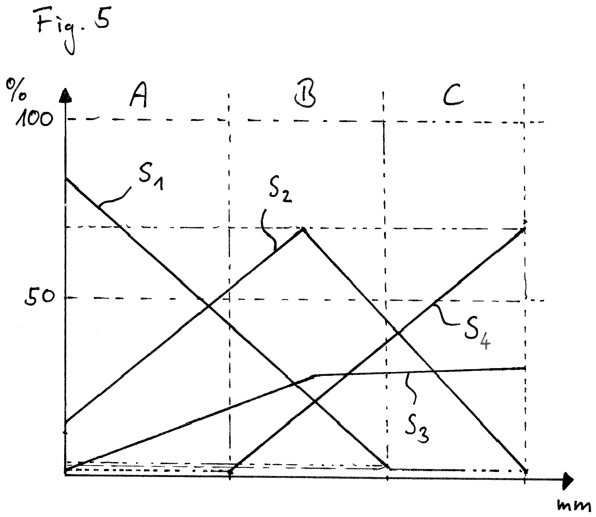

Figur 5 zeigt schematisch anhand eines Diagramms die Zusammensetzung des Materials in mehreren Zonen A, B und C, die im Wesentlichen den in Figur 2 gezeigten Schichten 9, 8 und 7 entsprechen können.

Auf der x-Achse ist dabei die Entfernung von der zweiten Elektrode 3 in Millimetern aufgetragen, d.h. im Unterschied zu Figur 2 läge die zweite Elektrode 3 nicht rechts, sondern links im Bild. Auf der y-Achse ist der Anteil einer bestimmten Komponente in Prozent aufgetragen. Die Kurve S1 beschreibt den Anteil an Zusätzen eines pulverförmigen Halbleitermaterials, insbesondere Silizium oder Titanoxid. Der Anteil liegt mit etwa 85 % am höchsten in unmittelbarer Nähe zur zweiten Elektrode 3 und nimmt in den Zonen A und B, die den Schichten 9 und 8 der Figur 2 entsprechen können, bis auf wenige Prozent ab. In der Zone C sind keine Zusätze an Halbleitermaterial mehr vorhanden.

Die Kurve S2 beschreibt den Anteil des ersten Materials. Dieser Anteil ist am höchsten im Zentrum der Zone B mit etwa 70 % und fällt zur ersten Elektrode 2 hin auf wenige Prozent ab, zur zweiten Elektrode 3 hin auf etwa 14 %.

Die Kurve S3 beschreibt den Anteil des zweiten Materials in den Zonen A bis C. Dieser Anteil ist mit etwa 27 % am höchsten in unmittelbarer Nähe zur ersten Elektrode 2 und beträgt im Zentrum der Zone B immer noch etwa 25 %, fällt jedoch zur zweiten Elektrode 3 hin auf wenige Prozent ab.

Die Kurve S4 beschreibt den Anteil des dritten Materials. Während in der Zone A praktisch kein drittes Material vorhanden ist, nimmt dieser von wenigen Prozent an der Grenze zwischen den Zonen A und B bis auf etwa 70 % in unmittelbarer Nähe zur ersten Elektrode 2 hin zu.

Die Zonen A, B und C weisen demnach sehr unterschiedliche Zusammensetzungen auf. Während in der Zone A im Bereich des Lichteinfalls die Zusätze am Halbleitermaterial sowie das erste Material dominieren, dominiert in der Nähe der ersten Elektrode 2 das dritte Material, während Zusätze von Halbleitermaterial (Silizium oder Titanoxid) hier nicht mehr vorhanden sind. Die Dicken der einzelnen Zonen A, B und C können insbesondere im Bereich von 1 mm oder etwas darunter liegen.

Der ohmsche Widerstand des Materials in den einzelnen Zonen unterscheidet sich aufgrund der unterschiedlichen Zusammensetzung erheblich. Er ist am niedrigsten in unmittelbarer Nähe zur ersten Elektrode 2 in der Zone C und steigt zur Zone B hin zunächst linear und in der Zone A dann in etwa exponentiell an.

Die Darstellung in Figur 5 geht davon aus, dass sich die Materialzusammensetzung in den einzelnen Zonen kontinuierlich ändert. Dies stellt einen idealisierten Fall dar, der das grundsätzliche Prinzip illustrieren soll. Diesem Fall kann sich angenähert werden, indem das aktive Material 5 in sehr dünnen Schichten aufgedruckt wird, wobei die Zusammensetzung tatsächlich für jede sehr dünne Schicht variiert wird. Die dünnen Schichten entsprechen dabei nicht den Schichten 7, 8, 9, sondern sind wesentlich dünner. Es kann jedoch auch vorteilhaft sein, das aktive Material 5 auf andere Weise bereitzustellen, beispielsweise durch das Aufeinanderstreichen von Schichten eines pastösen Materials mit unterschiedlicher Zusammensetzung. In diesem Fall wird sich eine weniger kontinuierliche Veränderung der Zusammensetzung der Schichten ergeben, die jedoch vom Prinzip her der in Figur 5 gezeigten entspricht, bei der Zusätze von Halbleitermaterial zusammen mit dem ersten Material die Zusammensetzung in der Nähe der zweiten Elektrode 3 dominieren und das dritte Material in unmittelbarer Nähe zur ersten Elektrode 2 dominiert.

Einem Gedanken der Erfindung zufolge kann eine Membran, beispielsweise aus Zellstoff, als Selbstentladeschutz innerhalb einer Solarzelle verwendet werden. Die Solarzelle kann dabei insbesondere eine photoaktive Schicht mit einem organischen Halbleitermaterial aufweisen.

Einem weiteren Gedanken der Erfindung zufolge kann ein Schottky-Übergang zwischen einem (beispielsweise organischen) Halbleitermaterial und einem Metall, beispielsweise Aluminium, innerhalb einer photoaktiven Schicht einer Solarzelle verwendet werden. Der Schottky-Übergang bewirkt ein zusätzliches elektrisches Feld und verhindert eine Selbstentladung.

### Bezugszeichenliste

- 1: Photovoltaikzelle
- 2: erste Elektrode
- 3: zweite Elektrode
- 4: Metalloxidschicht
- 5: aktives Material
- 6: lichtdurchlässiges Isolationselement
- 7: erste Schicht
- 8: zweite Schicht
- 9: dritte Schicht
- 10: Membran
- 11: Isolierung
- 12: erste Hauptoberfläche
- 13: zweite Hauptoberfläche
- 14: erste Hauptoberfläche
- 15: zweite Hauptoberfläche
- 16: Schalter

## Patentansprüche

1. Organisches Halbleitermaterial, enthaltend einen Anteil 50 bis 80% amorphen Siliziums oder Titanoxids oder eines anderen Metalloxids oder einer Mischung daraus, wobei das amorphe Silizium und/oder Titanoxid und/oder das andere Metalloxid in Pulverform mit dem organischen Halbleitermaterial verknetet ist.

2. Organisches Halbleitermaterial nach Anspruch 1, wobei der Anteil des amorphen Siliziums und/oder Titanoxids und/oder des anderen Metalloxids ausgehend von einer Oberfläche des Halbleitermaterials abnimmt.

3. Organisches Halbleitermaterial nach Anspruch 1 oder 2,
wobei auf einer Oberfläche des Halbleitermaterials eine ITO-Schicht angeordnet ist.

4. Organisches Halbleitermaterial, herstellbar durch das folgende Verfahren:
- Herstellung eines Gemischs aus 47% Pyrolyseöl, 47% Triglyceriden sowie 6% Kaliumhydroxid und Erwärmung des Gemischs bis zur Vernetzung sowie nachfolgendes Abkühlen auf Raumtemperatur unter Feuchtigkeitsabschluss, um ein erstes Material zu erhalten;
- Zugabe von 0,5% bis 2% eines Stoffes ausgewählt aus der Gruppe bestehend aus Kaliumhydroxid, Natriumhydroxid und Lithiumhydroxid zu einer Menge von Pyrolyseöl, Erwärmung des Gemischs auf eine Temperatur zwischen 100°C und 250°C unter laminarem Rühren sowie nachfolgendes Abkühlen des Gemischs auf Raumtemperatur und Zentrifugieren des Gemischs, um ein klares Öl sowie einen Bodensatz als zweites Material zu erhalten;
- Destillieren einer Mischung aus dem ersten Material und dem zweiten Material bei einer Destillationstemperatur von 120°C bis 300°C, um den Rückstand als drittes Material zu erhalten;
- Kombinieren des ersten, zweiten und dritten Materials zu einem Aufbau mit inhomogener Zusammensetzung.

5. Organisches Halbleitermaterial nach Anspruch 4,
wobei in dem Aufbau mit inhomogener Zusammensetzung eine Konzentration des dritten Materials in einer ersten Raumrichtung abnimmt.

6. Organisches Halbleitermaterial nach Anspruch 4 oder 5,
das Zusätze von Silizium und/oder Titanoxid aufweist, wobei in dem Aufbau mit inhomogener Zusammensetzung eine Konzentration des Siliziums und/oder Titanoxids in einer ersten Raumrichtung zunimmt.

7. Organisches Halbleitermaterial nach einem der Ansprüche 3 bis 5, aufweisend einen Schichtaufbau umfassend zumindest
- eine erste Schicht, die eine Zusammensetzung aus 60 bis 80% des dritten Materials, 20 bis 40% des zweiten Materials sowie 1 bis 5% des ersten Materials aufweist,
- eine benachbarte zweite Schicht, die eine Zusammensetzung von 60 bis 80% des ersten Materials, 20 bis 30% des zweiten Materials und wenigen Prozent des dritten Materials sowie Zusätzen von Silizium und/oder Titanoxid aufweist,
- eine zur zweiten Schicht benachbarte dritte Schicht, die eine Zusammensetzung von 80 bis 90% Silizium und/oder Titanoxid, 10 bis 18% des ersten Materials und 0,5 bis 3% des zweiten Materials aufweist.

8. Photovoltaikzelle, aufweisend
- eine erste Elektrode (2) mit einer ersten Hauptoberfläche (12) und einer zweiten Hauptoberfläche (14);
- eine zweite Elektrode (3) mit einer ersten Hauptoberfläche (13) und einer zweiten Hauptoberfläche (15);
- zumindest eine Schicht (7, 8, 9) des organischen Halbleitermaterials nach einem der Ansprüche 1 bis 7, wobei die Schicht (7, 8, 9) zwischen der zweiten Hauptoberfläche (14) der ersten Elektrode (2) und der ersten Hauptoberfläche (13) der zweiten Elektrode (3) angeordnet ist.

9. Photovoltaikzelle nach Anspruch 8,
wobei zumindest drei Schichten (7, 8, 9) des organischen Halbleitermaterials zwischen der zweiten Hauptoberfläche (14) der ersten Elektrode (2) und der ersten Hauptoberfläche (13) der zweiten Elektrode (3) angeordnet sind und der Anteil des dritten Materials mit zunehmender Entfernung der Schicht (7, 8, 9)von der ersten Elektrode (2) abnimmt und der Anteil des ersten Materials in der mittleren Schicht (8) am höchsten ist.

10. Photovoltaikzelle nach Anspruch 8 oder 9,
wobei zumindest drei Schichten (7, 8, 9) des organischen Halbleitermaterials zwischen der zweiten Hauptoberfläche (14) der ersten Elektrode (2) und der ersten Hauptoberfläche (13) der zweiten Elektrode (3) angeordnet sind und ein Anteil von Zusätzen aus Silizium oder Titanoxid im Bereich benachbart zur zweiten Elektrode (3) am höchsten ist.

11. Photovoltaikzelle nach einem der Ansprüche 8 bis 10,
wobei die erste Elektrode (2) Kohlenstoff aufweist.

12. Photovoltaikzelle nach einem der Ansprüche 8 bis 11,
wobei die zweite Elektrode (3) transparent ausgebildet ist.

13. Photovoltaikzelle nach einem der Ansprüche 10 bis 12,
wobei zwischen zwei der zumindest drei Schichten (7, 8, 9) eine teildurchlässige Membran (10) angeordnet ist.
